# EUROPÄISCHE PATENTSCHRIFT

(11) **EP 0 917 417 B1**
(45) Veröffentlichungstag und Bekanntmachung des Hinweises auf die Patenterteilung: **08.09.2004**
(21) Anmeldenummer: 98120818.4
(22) Anmeldetag: 03.11.1998
(51) Int. Cl.: H05K 7/14, H05K 7/20

(54) **Verfahren zur Erzeugung einer Montageplatte**
Method for producing a mounting plate
Procédé de fabrication d'une platine

(30) Priorität: 14.11.1997 DE 19750433
(43) Veröffentlichungstag der Anmeldung: 19.05.1999
(73) Patentinhaber: Conti Temic Microelectronic GmbH, 90411 Nürnberg (DE)
(72) Erfinder: Elipe, Mustafa, 91522 Ansbach (DE); Oed, Harald, 90475 Nürnberg (DE); Flierl, Werner, 92237 Sulzbach-Rosenberg (DE)

(56) Entgegenhaltungen:
- FR-A- 2 718 895
- US-A- 3 611 046
- PATENT ABSTRACTS OF JAPAN vol. 014, no. 375 (M-1010), 14. August 1990 (1990-08-14) & JP 02 137620 A (TOKIN CORP), 25. Mai 1990 (1990-05-25)
- PATENT ABSTRACTS OF JAPAN vol. 1996, no. 10, 31. Oktober 1996 (1996-10-31) & JP 08 153986 A (TOSHIBA CORP), 11. Juni 1996 (1996-06-11)
- PATENT ABSTRACTS OF JAPAN vol. 015, no. 419 (E-1126), 24. Oktober 1991 (1991-10-24) & JP 03 175698 A (MITSUBISHI ELECTRIC CORP), 30. Juli 1991 (1991-07-30)
- PATENT ABSTRACTS OF JAPAN vol. 017, no. 706 (E-1483), 22. Dezember 1993 (1993-12-22) & JP 05 243756 A (NEC CORP), 21. September 1993 (1993-09-21)
- PATENT ABSTRACTS OF JAPAN vol. 1996, no. 06, 28. Juni 1996 (1996-06-28) & JP 08 056086 A (FUJITSU TEN LTD), 27. Februar 1996 (1996-02-27)
- PATENT ABSTRACTS OF JAPAN vol. 1998, no. 02, 30. Januar 1998 (1998-01-30) & JP 09 260871 A (KYOCERA CORP;TAITO CORP), 3. Oktober 1997 (1997-10-03)

## Beschreibung

Bei einer Montageplatte bestimmt deren Dicke die Festigkeit einer Schraubverbindung zwischen der Montageplatte und einer in eine Montageöffnung der Montageplatte eingeschraubten Schraube.

Der Erfindung liegt die Aufgabe zugrunde, ein Verfahren zur Erzeugung einer Montageplatte der eingangs genannten Art anzugeben, durch das die Festigkeit der Schraubverbindung zwischen einer oder mehrerer Schrauben und der Montageplatte erhöht wird.

Die Aufgabe wird durch die Merkmale im Patentanspruch 1 gelöst. Vorteilhafte Weiterbildungen und Ausgestaltungen ergeben sich aus den Unteransprüchen.

Das wesen der Erfindung besteht demnach darin, die Materialdicke der Montageplatte im Bereich einer Montageöffnung zu erhöhen, indem mindestens eine an diesen Bereich angrenzende Vertiefung, vorzugsweise eine diese Montageöffnung ringförmig umschließende Vertiefung, in die Montageplatte eingepreßt wird. Hierzu wird die Montageplatte vorteilhafterweise kalt verformt.

Das Verfahren eignet sich bestens zur Herstellung von Montageplatten, die als Kühlkörper für elektronische Bauteile oder für Schaltungsträger mit elektronischen Bauteilen wirken.

Die Erfindung wird im folgenden anhand eines Ausführungsbeispiels unter Bezugnahme auf die Figuren näher beschrieben. Es zeigen:
- Figur 1: eine erfindungsgemäße Montageplatte in perspektivischer Darstellung,
- Figur 2: eine Detailansicht der Montageplatte aus Figur 1 mit einem Schaltungsträger in Schnittbilddarstellung.

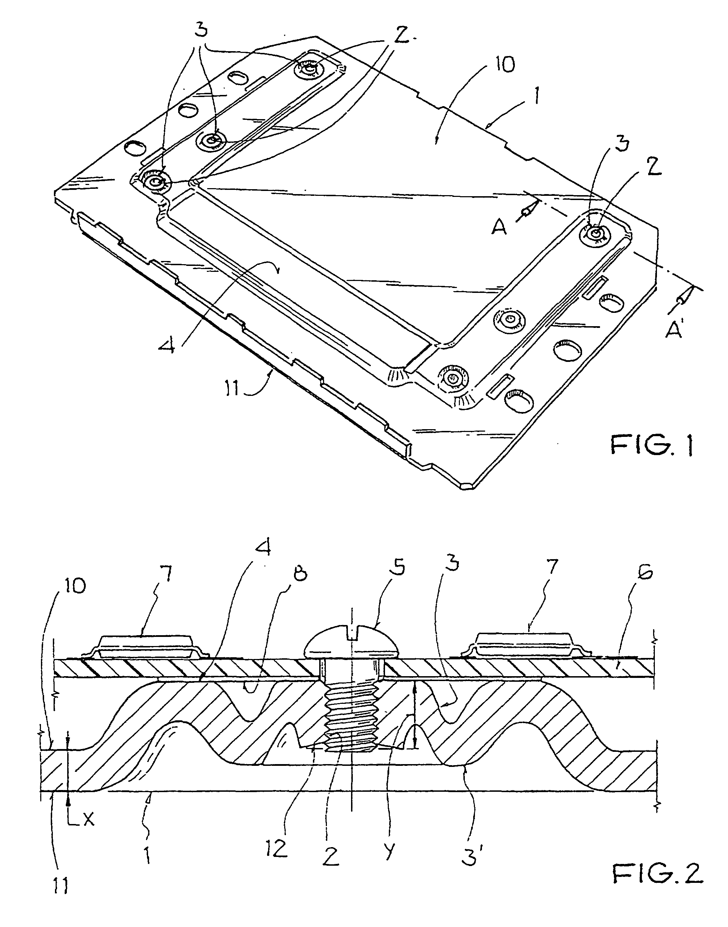

Die Montageplatte 1 aus Figur 1 wird aus einer Platte einheitlicher Dicke, beispielsweise aus einem ca. 2 mm dicken Aluminiumblech, gefertigt. Die Montageplatte 1 wird dabei zunächst, beispielsweise durch Bohren, gelocht, um die Montageöffnungen 2 zu erzeugen. In einem darauffolgenden Arbeitsschritt werden durch Kaltverformung die die obere Oberflächenseite 10, d. h. die Grundfläche der Montageplatte 1 überragende und zu dieser planparallele Auflagefläche 4 sowie die ringförmig um die Montageöffnungen 2 geführten Vertiefungen 3 gebildet.

Die Vertiefungen 3 werden dabei mittels eines Stempels in die Montageplatte 1 eingepreßt. Gemäß Figur 2, die ein Schnittbild der Montageplatte 1 entlang der Schnittlinie A - A' durch eine der Montageöffnungen 2, zeigt, wird durch die Formung der Vertiefungen 3 Material in Richtung der jeweiligen Montageöffnung 2 verschoben. Hierdurch wird die Materialdicke y der Montageplatte 1 im Bereich der Montageöffnungen 2 um etwa 50% gegenüber der ursprünglichen Dicke x der Montageplatte 1 erhöht, im Bereich der Vertiefungen 3 jedoch verringert. Des weiteren wird Material auch in Einpreßrichtung der Vertiefungen 3, d. h. senkrecht zur Grundfläche der Montageplatte 1, verschoben, so daß unter den Vertiefungen 3 auf der unteren Oberflächenseite 11 der Montageplatte 1 ringförmige Materialberge 3' entstehen, die die untere Oberfläche 12 der verdickten Bereiche überragen. Beim Handhaben der Montageplatte 1 wird durch diese Materialberge 3' die Verletzungsgefahr an den auf der unteren Oberflächenseite 11 der Montageplatte 1 entstehenden scharfkantigen Rändern der Vertiefungen 2 oder den in die Vertiefungen 2 eingeschraubten Schrauben 5 verringert.

Im vorliegenden Ausführungsbeispiel bildet die Montageplatte 1 einen Deckel für ein Gehäuse, in welches ein mit elektronischen Bauteilen 7 bestückter Schaltungsträger 6 eingebaut wird. Der Schaltungsträger 6 wird hierzu mit selbstschneidenden Schrauben 5, die in die Montageöffnungen 2 eingeschraubt werden, mit der Montageplatte 1 verbunden. Letztere wirkt gleichzeitig als Kühlkörper, wobei die thermische Kopplung zwischen dem Schaltungsträger 6 und der Montageplatte 1 dadurch verbessert wird, daß der Schaltungsträger 6 und die Montageplatte 1 mittels eines doppelseitigen Klebebandes 8, welches vor der Montage des Schaltungsträgers 6 auf die entfettete Auflagefläche 4 der Montageplatte 1 blasenfrei aufgebracht wird, miteinander verklebt werden.

## Patentansprüche

1. Verfahren zur Erzeugung einer Montageplatte (1), bei dem die Materialdicke der Montageplatte (1) im Bereich mindestens einer zum Einschrauben einer Schraube vorgesehenen Montageöffnung (2) durch Einpressung mindestens einer an diesen Bereich angrenzenden Vertiefung (3) erhöht wird.

2. Verfahren nach Anspruch 1, **dadurch gekennzeichnet, daß** die mindestens eine Vertiefung (3) durch Kaltpressung geformt wird.

3. Verfahren nach Anspruch 1 oder 2, **dadurch gekennzeichnet, daß** die mindestens eine Vertiefung (3) ringförmig um die mindestens eine Montageöffnung (2) geführt wird.

4. Verfahren nach einem der Ansprüche 1 bis 3, **dadurch gekennzeichnet, daß** mindestens im Bereich der mindestens einen Montageöffnung (2) eine die eine oberflächenseite (10) der Montageplatte (1) überragende und zu dieser planparallele Auflagefläche (4) für einen Schaltungsträger (6) durch Pressung geformt wird.

5. Verfahren nach einem der vorherigen Ansprüche zur Erzeugung einer Montageplatte (1) als Kühlkörper für ein elektronisches Bauteil (7) oder für einen mit elektronischen Bauteilen (7) bestückten Schaltungsträger (6).

## Claims

1. Method of producing a mounting plate (1), wherein in the region of at least one mounting opening (2) provided for screwing in a screw, the material thickness of the mounting plate (1) is increased by pressing in at least one depression (3) adjoining this region.

2. Method according to Claim 1, **characterised in that** the at least one depression (3) is formed by cold pressing.

3. Method according to Claim 1 or 2, **characterised in that** the at least one depression (3) is arranged in a ring shape around the at least one mounting opening (2).

4. Method according to one of Claims 1 to 3, **characterised in that** at least in the region of the at least one mounting opening (2), a supporting surface (4) for a circuit carrier (6), which surface projects above a surface side (10) of the mounting plate (1) and is plane parallel to this, is formed by pressing.

5. Method according to one of the preceding claims of producing a mounting plate (1) as cooling body for an electronic component (7) or for a circuit carrier (6) fitted with electronic components (7).

## Revendications

1. Procédé de fabrication d'une platine de montage (1), d'après lequel on augmente l'épaisseur de matériau de la platine de montage (1) dans la zone d'au moins une ouverture de montage (2) prévue pour le vissage d'une vis, par la formation à la presse d'au moins une empreinte en creux (3) adjacente à ladite zone.

2. Procédé selon la revendication 1, **caractérisé en ce que** ladite au moins une empreinte en creux (3) est formée par matriçage à froid.

3. Procédé selon la revendication 1 ou 2, **caractérisé en ce que** ladite au moins une empreinte en creux (3) entoure de manière annulaire ladite au moins une ouverture de montage (2).

4. Procédé selon l'une des revendications 1 à 3, **caractérisé en ce qu'**au moins dans la zone de ladite au moins une ouverture de montage (2), est réalisée, par formage à la presse, une surface d'appui (14) qui est destinée à un support de circuit (6), et se situe à un niveau au-dessus de la surface d'une des faces (10) de la platine de montage (1) et est parallèle au plan de celle-ci.

5. Procédé selon l'une des revendications précédentes, destiné à la fabrication d'une platine de montage (1) en tant que corps de refroidissement ou dissipateur de chaleur pour un composant électronique (7) ou un support de circuit (6) équipé de composants électroniques (7).
